# EUROPEAN PATENT APPLICATION

(11) **EP 4 477 289 A1**
(43) Date of publication of application: **18.12.2024**
(21) Application number: 23815173.2
(22) Date of filing: 29.05.2023
(51) Int. Cl.: B01D 35/02, B01D 29/58

(54) **FILTER DEVICE AND ELECTRONIC APPARATUS**

(30) Priority: 31.05.2022 CN 202210611368
(71) Applicant: Huawei Technologies Co., Ltd., Shenzhen, Guangdong 518129 (CN)
(72) Inventor: LIN, Nan, Shenzhen, Guangdong 518129 (CN); ZHAO, Menglong, Shenzhen, Guangdong 518129 (CN); HE, Qian, Shenzhen, Guangdong 518129 (CN); YANG, Wenjian, Shenzhen, Guangdong 518129 (CN); ZHANG, Kemin, Shenzhen, Guangdong 518129 (CN); LIU, Zhuang, Shenzhen, Guangdong 518129 (CN)
(74) Representative: MERH-IP Matias Erny Reichl Hoffmann Patentanwälte PartG mbB
(86) International application number: PCT/CN2023/096967
(87) International publication number: WO 2023/231994

(57) **Abstract**

Embodiments of this application pertain to the field of terminal device technologies, and in particular, to a filtration apparatus and an electronic device. Embodiments of this application are intended to resolve a problem of a sealing failure of a housing body that is caused because particulate matter in water is likely to damage a waterproof membrane. In the filtration apparatus and the electronic device provided in embodiments, a first filter layer is disposed on an outer side of an outer surface of a housing body, a second filter layer is disposed between the outer surface and the first filter layer, and both the first filter layer and the second filter layer cover function holes on the housing body. In this way, the first filter layer and the second filter layer can filter water that enters the function holes, to prevent impurities such as particulate matter in the water from entering the function holes. In a deep water environment, the impurities such as particulate matter can be prevented from damaging the waterproof membrane, so that waterproof performance of the electronic device in the deep water environment is improved. That is, a capability of the electronic device to withstand water pressure is improved, and an underwater usability depth of the electronic device is increased.

## Description

This application claims priority to Chinese Patent Application No. 202210611368.6, filed with the China National Intellectual Property Administration on May 31, 2022 and entitled "FILTRATION APPARATUS AND ELECTRONIC DEVICE", which is incorporated herein by reference in its entirety.

### TECHNICAL FIELD

Embodiments of this application relate to the field of terminal device technologies, and in particular, to a filtration apparatus and an electronic device.

### BACKGROUND

A microphone is usually disposed in an electronic device (for example, a smart watch or a mobile phone), so that external acoustic waves can be collected by using the microphone. Specifically, the electronic device further includes a housing body and a waterproof membrane. The housing body is provided with function holes that penetrate through the housing body, the microphone is disposed on the housing body and is disposed facing the function holes, and the function holes are sealed by the waterproof membrane. During operation, the acoustic waves pass through the function holes and the waterproof membrane, and are received by the microphone. The waterproof membrane may prevent external water from entering the function holes, so that sealing of the housing body is implemented.

However, in a deep water environment, water pressure is relatively high. In this case, particulate matter in the water easily damages the waterproof membrane, and a sealing failure of the housing body is likely to be caused.

### SUMMARY

Embodiments of this application provide a filtration apparatus and an electronic device, to resolve a problem of a sealing failure of a housing body that is caused because particulate matter in water is likely to damage a waterproof membrane.

According to one aspect, an embodiment of this application provides a filtration apparatus, configured to be disposed on an electronic device.

The electronic device includes:
a housing body, where the housing body has an inner surface and an outer surface opposite to the inner surface, and function holes that penetrate through the inner surface and the outer surface are provided on the housing body.

The filtration apparatus includes:
a first filter layer, where the first filter layer is located on an outer side of the outer surface, the first filter layer covers the function holes, and a plurality of first mesh holes are provided at intervals on the first filter layer;
a second filter layer, where the second filter layer is located between the outer surface and the first filter layer, the second filter layer covers the function holes, and a plurality of second mesh holes are provided at intervals on the second filter layer.

In a cross-section parallel to the first filter layer, a cross-section area of the first mesh hole is greater than a cross-section area of the second mesh hole.

In some embodiments that may include the foregoing embodiment, there are a plurality of second filter layers, and the plurality of second filter layers are arranged in a laminated manner; and in the cross-section parallel to the first filter layer, a cross-section area of the second mesh hole on each second filter layer gradually increases along a direction away from the outer surface.

In some embodiments that may include the foregoing embodiment, the filtration apparatus further includes:
a first bonding layer, where the first bonding layer is disposed between the first filter layer and the second filter layer close to the first filter layer and between adjacent second filter layers, and first through-holes that communicate with the function holes are provided on the first bonding layer.

In some embodiments that may include the foregoing embodiment, the filtration apparatus further includes:
a first support layer, where the first support layer is disposed between the second filter layer and the outer surface, the first support layer is attached to the outer surface, and second through-holes that communicate with the function holes are provided on the first support layer.

In some embodiments that may include the foregoing embodiment, the first filter layer is a rigid filter layer.

In some embodiments that may include the foregoing embodiment, there are two second filter layers, the two second filter layers are arranged in a laminated manner, the first filter layer is located between the two second filter layers, and in the cross-section parallel to the first filter layer, a cross-section area on the second mesh hole of each second filter layer gradually increases along a direction away from the outer surface.

In some embodiments that may include the foregoing embodiment, the filtration apparatus further includes:
a first bonding layer, where the first bonding layer is disposed between the first filter layer and the second filter layer, and first through-holes that communicate with the function holes are provided on the first bonding layer.

In some embodiments that may include the foregoing embodiment, the filtration apparatus further includes:
a cover plate, where the cover plate covers the outer surface, the first filter layer and the second filter layer are located between the cover plate and the outer surface, and third through-holes that communicate with the function holes are provided on the cover plate.

The cover plate is connected to the housing body.

In some embodiments that may include the foregoing embodiment, the filtration apparatus further includes:
a second bonding layer, where the second bonding layer is disposed between the cover plate and the first filter layer, and fourth through-holes that communicate with the function holes are provided on the second bonding layer.

In some embodiments that may include the foregoing embodiment, a first groove is provided on a surface that is of the cover plate and that faces the housing body, and at least a part of the first filter layer is accommodated in the first groove.

In some embodiments that may include the foregoing embodiment, a second groove is provided on the outer surface, and at least a part of the second filter layer is accommodated in the second groove.

In some embodiments that may include the foregoing embodiment, the electronic device further includes a sound module, the sound module is disposed on the inner surface, and the sound module is disposed at the function hole.

According to another aspect, an embodiment of this application further provides an electronic device, including:
a housing body, where the housing body has an inner surface and an outer surface opposite to the inner surface, and function holes that penetrate through the inner surface and the outer surface are provided on the housing body; and
a waterproof assembly, where the waterproof assembly is disposed on the function hole, and the waterproof assembly is configured to prevent liquid from passing through the function hole; and
the filtration apparatus described above.

In some embodiments that may include the foregoing embodiment, the waterproof assembly is disposed on the inner surface, and the waterproof assembly includes:
a waterproof membrane, a third bonding layer, a second support layer, and a fourth bonding layer that are arranged in a laminated manner along a direction away from the inner surface, where a fifth through-hole is provided on the third bonding layer, a sixth through-hole is provided on the fourth bonding layer, and both the fifth through-hole and the sixth through-hole communicate with the function holes.

A plurality of first holes are provided at intervals in a region that is of the second support layer and that faces the function holes.

In some embodiments that may include the foregoing embodiment, the waterproof assembly further includes a buffer layer, the buffer layer is disposed on a side that is of the fourth bonding layer and that is away from the inner surface, and a seventh through-hole that communicates with the function hole is provided on the buffer layer.

In some embodiments that may include the foregoing embodiment, the waterproof assembly further includes:
a fifth bonding layer, where the fifth bonding layer is disposed between the waterproof membrane and the inner surface, and an eighth through-hole that communicates with the function hole is provided on the fifth bonding layer.

In some embodiments that may include the foregoing embodiment, the waterproof assembly further includes:
a third support layer, where the third support layer is disposed on the inner surface, and an accommodating channel that communicates with the function hole is provided on the third support layer.

The waterproof membrane is accommodated in the accommodating channel, an edge of the waterproof membrane is attached to a side wall of the accommodating channel, and an interstice exists between the waterproof membrane and the inner surface.

In some embodiments that may include the foregoing embodiment, the second support layer is in contact with a surface that is of the third support layer and that is away from the inner surface.

In some embodiments that may include the foregoing embodiment, the third support layer includes a silicone layer.

In some embodiments that may include the foregoing embodiment, the second support layer and the third support layer are of an integrated structure.

In some embodiments that may include the foregoing embodiment, a sealing ring is disposed between the third support layer and the housing body, and the sealing ring is disposed surrounding the function hole.

In some embodiments that may include the foregoing embodiment, the waterproof assembly further includes:
an auxiliary support layer, where the auxiliary support layer is disposed between the third support layer and the inner surface, a plurality of second holes are provided at intervals in a region that is of the auxiliary support layer and that faces the function hole, and the interstice is located between the waterproof membrane and the auxiliary support layer.

In some embodiments that may include the foregoing embodiment, the auxiliary support layer and the third support layer are of an integrated structure.

In some embodiments that may include the foregoing embodiment, a sixth bonding layer is disposed between the third support layer and the second support layer, a ninth through-hole is provided on the sixth bonding layer, the third bonding layer is located in the ninth through-hole, and the third bonding layer is bonded to a hole wall of the ninth through-hole.

In some embodiments that may include the foregoing embodiment, the waterproof assembly further includes:
a protective layer, where the protective layer is disposed on a surface that is of the waterproof membrane and that faces the inner surface, and a via hole that communicates with the function hole is provided on the protective layer.

In some embodiments that may include the foregoing embodiment, a first accommodating groove is provided on the inner surface, and the waterproof assembly is disposed in the first accommodating groove.

In some embodiments that may include the foregoing embodiment, the waterproof assembly is disposed on the outer surface, and the waterproof assembly includes:
a third bonding layer, a waterproof membrane, and a protective layer that are arranged in a laminated manner along a direction away from the outer surface, where a fifth through-hole that communicates with the function hole is provided on the third bonding layer, and a via hole that is directly opposite to the function hole is provided on the protective layer.

In some embodiments that may include the foregoing embodiment, the waterproof assembly further includes a second support layer, the second support layer is disposed between the third bonding layer and the outer surface, and a plurality of first holes are provided at intervals in a region that is of the second support layer and that faces the function holes.

In some embodiments that may include the foregoing embodiment, a second accommodating groove is provided on the outer surface, and the waterproof assembly is disposed in the second accommodating groove.

In some embodiments that may include the foregoing embodiment, the electronic device further includes a sound module, the sound module is disposed on the inner surface, and the sound module is disposed at the function hole.

In the filtration apparatus and the electronic device provided in embodiments of this application, the first filter layer is disposed on the outer surface of the housing body, and a plurality of first mesh holes are provided at intervals on the first filter layer. The second filter layer is disposed between the outer surface and the first filter layer, a plurality of second mesh holes are provided at intervals on the second filter layer, and both the first filter layer and the second filter layer cover the function holes on the housing body. In this way, the first filter layer and the second filter layer can filter water that enters the function holes, to prevent impurities such as particulate matter in the water from entering the function holes. In a deep water environment, the impurities such as particulate matter can be prevented from damaging the waterproof membrane, so that waterproof performance of the electronic device in the deep water environment is improved. That is, a capability of the electronic device to withstand water pressure is improved, and an underwater usability depth of the electronic device is increased.

### BRIEF DESCRIPTION OF DRAWINGS

FIG. 1 is a rear view of a smart watch;
FIG. 2 is a schematic diagram of a structure of a waterproof assembly in related technologies;
FIG. 3 is a schematic diagram 1 of a structure of an electronic device according to an embodiment of this application;
FIG. 4 is a schematic diagram 1 of a connection between a first filter layer and a cover plate in a filtration apparatus according to an embodiment of this application;
FIG. 5 is a partially enlarged view of location A in FIG. 4;
FIG. 6 is an exploded view of a first filter layer and a second filter layer in FIG. 4;
FIG. 7 is a schematic diagram 2 of a structure of an electronic device according to an embodiment of this application;
FIG. 8 is a schematic diagram 2 of a connection between a first filter layer and a cover plate in a filtration apparatus according to an embodiment of this application;
FIG. 9 is a partially enlarged view of location B in FIG. 8;
FIG. 10 is an exploded view of a first filter layer and a second filter layer in FIG. 8;
FIG. 11 is a partially enlarged view of location C in FIG. 8;
FIG. 12 is a schematic diagram of a structure of a housing body in an electronic device according to an embodiment of this application;
FIG. 13 is a schematic diagram of a structure in which a first filter layer is disposed between two second filter layers in a filtration apparatus according to an embodiment of this application;
FIG. 14 is a schematic diagram 3 of a structure of an electronic device according to an embodiment of this application;
FIG. 15 is a schematic diagram 4 of a structure of an electronic device according to an embodiment of this application;
FIG. 16 is a schematic diagram 5 of a structure of an electronic device according to an embodiment of this application;
FIG. 17 is a schematic diagram 6 of a structure of an electronic device according to an embodiment of this application;
FIG. 18 is a schematic diagram 7 of a structure of an electronic device according to an embodiment of this application; and
FIG. 19 is a schematic diagram 8 of a structure of an electronic device according to an embodiment of this application.

Reference numerals:
10: filtration apparatus;
101: first filter layer;
102: second filter layer;
103: first bonding layer;
104: second bonding layer;
105: first support layer;
106: cover plate;
1011: first mesh hole;
1021: second mesh hole;
1031: first through-hole;
1041: fourth through-hole;
1051: second through-hole;
1061: third through-hole;
1062: first groove;
20: housing body;
201: inner surface;
202: outer surface;
203: function hole;
204: glue containing groove;
205: first accommodating groove;
206: second groove;
207: second accommodating groove;
2011: first housing wall;
2021: second housing wall;
2051: first groove bottom;
2071: second groove bottom;
30: waterproof assembly;
301: waterproof membrane;
302: third bonding layer;
303: second support layer;
304: fourth bonding layer;
305: buffer layer;
306: fifth bonding layer;
307: third support layer;
308: protective layer;
3021: fifth through-hole;
3023: sixth bonding layer;
3024: ninth through-hole;
3031: first hole;
3032: auxiliary support layer;
3033: second hole;
3034: seventh bonding layer;
3035: tenth through-hole;
3041: sixth through-hole;
3051: seventh through-hole;
3061: eighth through-hole;
3071: accommodating channel;
3072: interstice;
3073: sealing ring;
3074: ring groove;
3081: via hole;
40: sound module;
401: microphone;
402: speaker.

### DESCRIPTION OF EMBODIMENTS

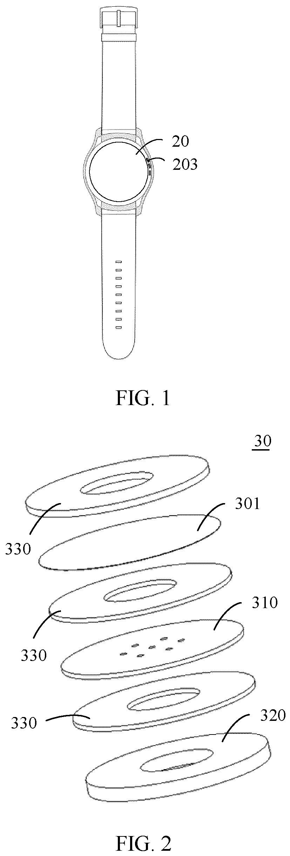

With the gradual development of terminal device technologies, electronic devices such as mobile phones and smart watches have been widely used. In order to improve performance of an electronic device, a waterproof design is often required for the electronic device. As shown in FIG. 1, a smart watch, in related technologies, includes a housing body 20, a microphone, and a waterproof assembly. Function holes 203 are provided on the housing body 20, the microphone is disposed at the function holes, and the waterproof assembly is configured to block the function holes, to prevent water from passing through and allow acoustic waves to pass through, so that sealing of the function holes 203 is implemented.

Refer to FIG. 2. A waterproof assembly 30 includes a waterproof membrane 301, a steel sheet 310, and foam 320 that are arranged in a laminated manner. A bonding layer 330 is disposed between the waterproof membrane 301 and the housing body 20, between the waterproof membrane 301 and the steel sheet 310, and between the steel sheet 310 and the foam 320, to implement fastening of each film layer. A plurality of holes are provided on the steel sheet 310. Because the waterproof membrane 301 has a micro-pore structure, acoustic waves from the outside may pass through the micro-pore structure, sequentially pass through the holes and the function holes, and be received by the microphone. Water has surface tension, and it is difficult for water to pass through the micro-pore structure, so that sealing between the housing body 20 and the outside is implemented. When the electronic device is placed in water, as a water depth increases, water pressure gradually increases. In this case, impurities such as particulate matter in the water damage the micro-pore structure, and the water can pass through the waterproof membrane 301 and enter the housing, causing a sealing failure of the housing body 20 and a waterproof failure of the electronic device in a deep water environment.

To make objectives, technical solutions, and advantages of embodiments of this application clearer, the following clearly describes the technical solutions in embodiments of this application with reference to the accompanying drawings in embodiments of this application. It is clear that the described embodiments are merely some rather than all of embodiments of this application. All other embodiments obtained by a person of ordinary skill in the art based on embodiments of this application without creative efforts shall fall within the protection scope of this application.

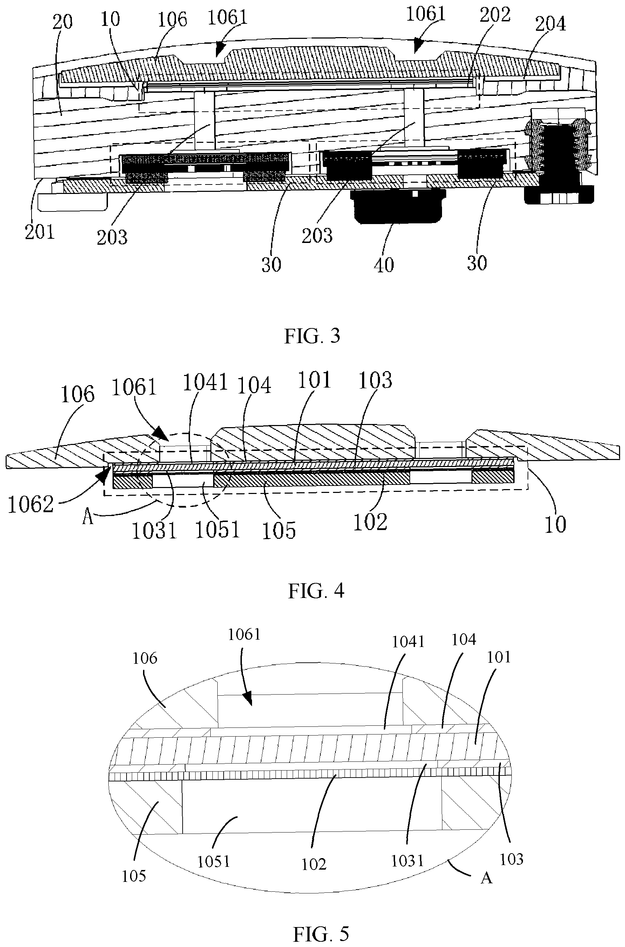

Refer to FIG. 1 and FIG. 3. An embodiment of this application provides a filtration apparatus 10 used in an electronic device. The filtration apparatus 10 is configured to be disposed on the electronic device. For example, the electronic device may include a terminal device such as a mobile phone, a smart watch (as shown in FIG. 1), a PC, a tablet computer, a VR, an AR, or a headset. The electronic device is not limited in this embodiment.

The electronic device may include a housing body 20, the housing body 20 may be a housing of the electronic device, and the housing body 20 is disposed around a cavity and is configured to accommodate apparatuses such as a battery (not shown) and a circuit board (not shown) in the electronic device. The housing body 20 has an inner surface 201 and an outer surface 202 that are disposed opposite to each other. It may be understood that the inner surface 201 may be a surface that faces the inside of the electronic device (for example, a cavity wall of a cavity), and correspondingly, the outer surface 202 is an exposed surface of the housing body 20. The housing body 20 is provided with function holes 203 that penetrate through the inner surface 201 and the outer surface 202. The function hole 203 may be a balance hole (for example, the function hole 203 on the left side in FIG. 3). The balance hole may balance atmospheric pressure inside and outside the housing body, so that a speaker and a microphone can work normally.

Certainly, the function hole 203 may also be a hole (for example, the function hole 203 on the right side in FIG. 3) for acoustic waves to pass through. The electronic device further includes a sound module 40. The sound module 40 is disposed on the inner surface 201, that is, the sound module 40 is located in the cavity, and the sound module 40 is disposed at the function hole 203. For example, the sound module 40 may include a speaker. Correspondingly, the sound module 40 may send acoustic waves to the outside of the housing body 20 through the function hole 203. Certainly, the sound module 40 may also include a microphone. Correspondingly, the sound module 40 receives acoustic waves outside the housing body 20 through the function hole 203, to obtain an external sound signal. The sound module 40 is not limited in this embodiment.

Refer to FIG. 3 and FIG. 4. The filtration apparatus 10 provided in this embodiment includes a first filter layer 101. The first filter layer 101 is disposed on an outer side (upper part in the direction shown in FIG. 3) of the outer surface 202, and the first filter layer 101 has a plurality of first mesh holes (not shown) provided at intervals. The first filter layer 101 covers the function holes 203, to be specific, the function holes 203 are located inside a projection on the outer surface 202 of the first filter layer 101, so that the first filter layer 101 and the first mesh holes on the first filter layer 101 can filter water that enters the function holes 203, to prevent impurities such as particulate matter in the water from entering the function holes 203.

Refer to FIG. 4 and FIG. 5. The filtration apparatus 10 further includes a second filter layer 102. The second filter layer 102 is located between the outer surface 202 and the first filter layer 101, and the second filter layer 102 has a plurality of second mesh holes (not shown) provided at intervals. The second filter layer 102 covers the function holes 203, to be specific, the function holes 203 are located inside a projection on the outer surface 202 of the second filter layer 102, so that the second filter layer 102 and the second mesh holes on the second filter layer 102 can also filter water that enters the function holes 203, to further prevent impurities such as particulate matter in the water from entering the function holes 203. Both the first filter layer 101 and the second filter layer 102 may filter water that enters the function holes 203, and may further prevent impurities such as particulate matter in the water from entering the function holes 203.

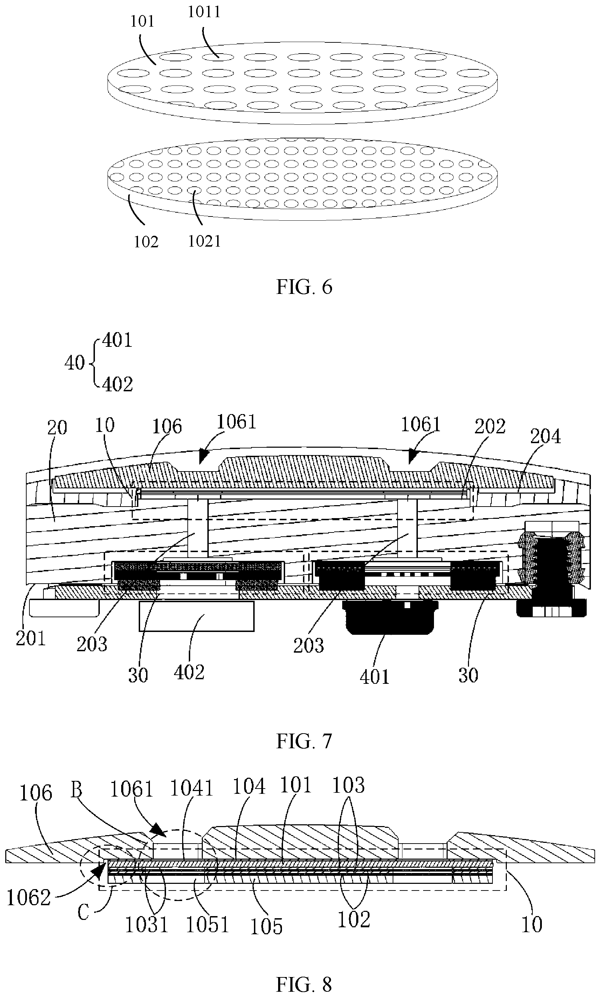

Refer to FIG. 6. In the foregoing implementation, in a cross-section parallel to the first filter layer 101, a cross-section area of a first mesh hole 1011 is greater than a cross-section area of a second mesh hole 1021. In other words, a projected area of the first mesh hole 1011 on the outer surface 202 is greater than a projected area of the second mesh hole 1021 on the outer surface 202. In this way, the first filter layer 101 can prevent impurities with a relatively large particle size from passing through, and the second filter layer 102 can prevent impurities with a relatively small particle size from passing through. Compared with a case in which only one filter layer is disposed, accumulation of impurities with a large particle size can be avoided, so that the first filter layer 101 and the second filter layer 102 are avoided being blocked.

For example, cross-sections of the first mesh hole 1011 and the second mesh hole 1021 may be in a regular shape such as a rectangle or a circle. Certainly, the cross-sections of the first mesh hole 1011 and the second mesh hole 1021 may be in an irregular shape. In an implementation in which the cross-sections of the first mesh hole 1011 and the second mesh hole 1021 are circular, an aperture of the first mesh hole 1011 may be 0.1 mm to 0.5 mm (including 0.1 and 0.5), and a thickness of the first filter layer 101 may be 0.1 mm to 0.3 mm (including 0.1 and 0.3). Correspondingly, an aperture of the second mesh hole may be 0.5 µm to 100 µm (including 0.5 and 100 µm), and a thickness of the second filter layer 102 may be 0.05 mm to 0.1 mm (including 0.05 and 0.1). In this way, relatively good filtration effect is ensured, and a loss of acoustic waves when passing through the first filter layer 101 and the second filter layer 102 is relatively small. In addition, the thickness of the first filter layer 101 and the thickness of the second filter layer 102 are relatively small, which can improve structural compactness of the electronic device.

In this embodiment, the first filter layer 101 may be a rigid filter layer. In other words, the first filter layer 101 may be made of a material with rigidity, such as a steel mesh, a perforated steel sheet, or a perforated plastic plate. Because the first filter layer 101 is an outermost filter layer, in this way, the first filter layer 101 is disposed to filter relatively hard and sharp impurities (such as sandstone and metal particulate matter), so that impurities such as particulate matter can be prevented from damaging the first filter layer 101. In addition, because the first filter layer 101 has rigidity, the first filter layer 101 can support the second filter layer 102 and the like, so that the second filter layer 102 and the like are prevented from being winkled. Correspondingly, the second filter layer 102 may be a filter layer with flexibility. For example, the second filter layer 102 may include a dust filter, and a material of the dust filter may include polyethylene terephthalate (polyethylene terephthalate, PET), poly (ether-ether-ketone) (poly (ether-ether-ketone), PEEK), and the like.

Still refer to FIG. 3. It can be learned from the foregoing that in this embodiment, the electronic device further includes a waterproof assembly 30, the waterproof assembly 30 is disposed on the housing body 20, and the waterproof assembly 30 blocks the function hole 203, to implement sealing of the function hole 203. The waterproof assembly 30 may be disposed on the inner surface 201 of the housing body 20, and the waterproof assembly 30 is located between the sound module 40 and the inner surface 201. The waterproof assembly 30 allows acoustic waves to pass through, and the waterproof assembly 30 prevents water from passing through. Certainly, the waterproof assembly 30 may also be located on the inner side of the balance hole (for example, the function hole 203 on the left side in FIG. 3). In this case, the waterproof assembly 30 allows air to pass through and prevents water from passing through. For example, the waterproof assembly 30 may include a waterproof and breathable membrane. The waterproof and breathable membrane has a micro-pore structure, and some air may pass through the micro-pore structure. Water has surface tension, and it is difficult for water to pass through the micro-pore structure, so that the waterproof assembly 30 can prevent water from passing through and allow acoustic waves and air to pass through, and sealing is implemented. A material of the waterproof and breathable membrane may include expanded PTFE (expanded PTFE, e-PTFE), and the like. A hole diameter of the micro-pore structure in the waterproof and breathable membrane may range from 0.05 µm to 10 µm, for example, 0.085 µm, 0.1 µm, or the like. In this way, waterproof effect of the waterproof and breathable membrane can be improved, to increase an underwater usability depth of the electronic device. Certainly, the waterproof and breathable membrane may also transfer acoustic waves from one side of the waterproof and breathable membrane to the other side through vibration of the waterproof and breathable membrane.

Refer to FIG. 7. Two function holes 203 may be provided on the housing body 20. Correspondingly, the sound module 40 may include a speaker 402 and a microphone 401. The speaker 402 is disposed to face one function hole 203, and the microphone 401 is disposed to face the other function hole 203. In other words, the speaker 402 sends acoustic waves to the outside of the housing body 20 through the function hole 203 corresponding to the speaker 402, and the microphone 401 receives external acoustic waves through the function hole 203 corresponding to the microphone 401. Correspondingly, a waterproof assembly 30 is disposed between the speaker 402 and the inner surface 201, and between the microphone 401 and the inner surface 201, to implement sealing of the two function holes 203.

It may be understood that, in the foregoing implementation, the filtration apparatus 10 may cover two function holes 203, to be specific, both the two function holes 203 are located inside projections of the first filter layer 101 and the second filter layer 102 on the outer surface 202. In this way, the first filter layer 101 and the second filter layer 102 may be used to filter water that enters the two function holes 203.

Certainly, in some implementations, there may be two filtration apparatuses 10, where one filtration apparatus 10 is disposed to correspond to one function hole 203, and the other filtration apparatus 10 is disposed to correspond to the other function hole 203. In other words, the first filter layer 101 and the second filter layer 102 in one filtration apparatus 10 covers one function hole 203, and the function hole 203 is located inside projections of the first filter layer 101 and the second filter layer 102 on the outer surface 202. The first filter layer 101 and the second filter layer 102 in the other filtration apparatus 10 cover the other function hole 203, and the function hole 203 is located inside projections of the first filter layer 101 and the second filter layer 102 on the outer surface 202. In this way, each filtration apparatus 10 may filter water that enters the corresponding function hole 203.

In the filtration apparatus 10 provided in this embodiment, the first filter layer 101 is disposed outside the outer surface 202 of the housing body 20, and a plurality of first mesh holes 1011 are provided at intervals on the first filter layer 101. The second filter layer 102 is disposed between the outer surface 202 and the first filter layer 101, a plurality of second mesh holes 1021 are provided at intervals on the second filter layer 102, and both the first filter layer 101 and the second filter layer 102 cover the function holes 203 on the housing body 20. In this way, in water, the first filter layer 101 and the second filter layer 102 may filter water that enters the function holes 203, to prevent impurities such as particulate matter in the water from entering the function holes 203. Especially in a deep water environment, impurities such as particulate matter may be prevented from damaging the waterproof membrane 301, so that waterproof performance of the electronic device in the deep water environment is improved, that is, a capability of the electronic device to withstand water pressure is improved, and an underwater usability depth of the electronic device is increased.

In addition, a cross-section area of the first mesh hole 1011 is greater than a cross-section area of the second mesh hole 1021. In this way, the first filter layer 101 can prevent impurities with a relatively large particle size from passing through, and the second filter layer 102 can prevent impurities with a relatively small particle size from passing through. Compared with a case in which only one filter layer is disposed, accumulation of impurities with a large particle size can be avoided, so that the filter layers are prevented from being blocked.

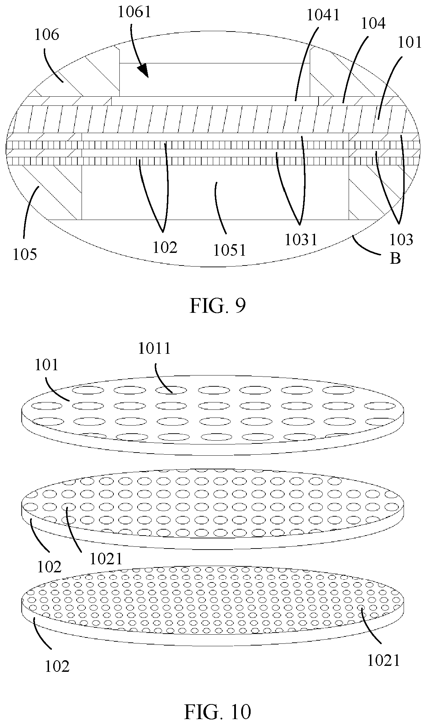

Refer to FIG. 8 and FIG. 9. In some embodiments, there may be a plurality of second filter layers 102, and the plurality of second filter layers 102 are arranged between the first filter layer 101 and the outer surface 202 in a laminated manner. In this way, the plurality of second filter layers 102 may further improve effect of filtering impurities such as particulate matter, to further improve waterproof performance of the electronic device in a deep water environment, and increase an underwater usability depth of the electronic device.

Refer to FIG. 9 and FIG. 10. In some implementations, in a cross-section parallel to the first filter layer 101 and along a direction away from the outer surface 202 (the upward direction in FIG. 10), a cross-section area of a second mesh hole 1021 on each second filter layer 102 gradually increases. To be specific, a cross-section area of a second mesh hole 1021 of the second filter layer 102 close to the first filter layer 101 is greater than a cross-section area of a second mesh hole 1021 of the second filter layer 102 away from the first filter layer 101. In this way, impurities with a relatively large particle size stay on the second filter layer 102 close to the first filter layer 101, and impurities with a relatively small particle size stay on the second filter layer 102 away from the first filter layer 101, so that impurities can be prevented from being accumulated on each second filter layer 102, and the second filter layers 102 are avoided being blocked. In other implementations, second mesh holes 1021 on all second filter layer 102 may have a same cross-section area.

In this embodiment, a quantity of second filter layers 102 may be two, three, four, or the like. The quantity of second filter layers 102 is not limited in this embodiment. As shown in FIG. 9, there are two second filter layers 102, and an aperture of a second mesh hole 1021 on the second filter layer 102 close to the first filter layer 101 may be 50 µm. Correspondingly, an aperture of a second mesh hole 1021 on the second filter layer 102 away from the first filter layer 101 may be 25 µm. In this case, relatively high filtration effect is ensured, and a loss of acoustic waves when passing through the filtration apparatus 10 may be reduced, so that acoustic performance of the electronic device is improved. Compared with a case in which the filtration apparatus 10 is not disposed, water pressure that can be withstood by the electronic device may reach 1.25 MPa (about 12.5 atm), that is, an underwater usability depth of the electronic device may reach 125 meters.

Still refer to FIG. 9. In an implementation in which the filtration apparatus 10 includes a plurality of second filter layers 102 disposed in a laminated manner, the filtration apparatus 10 further includes first bonding layers 103, where the first bonding layers 103 are disposed between the first filter layer 101 and the second filter layer 102 close to the first bonding layer 103, and between adjacent second filter layers 102. In this way, the first bonding layers 103 may implement bonding between the first filter layer 101 and the second filter layer 102 close to the first filter layer 101, and between the adjacent second filter layers 102. In addition, the first filter layer 101 and the second filter layer 102 close to the first filter layer 101, and the adjacent second filter layers 102 may be connected by the first bonding layers 103 to form a filter layer assembly, to implement pre-installation of the filtration apparatus 10. Then, the filter layer assembly is installed on the housing body 20, which facilitates installation of the electronic device.

First through-holes 1031 are provided on the first bonding layers 103, and the first through-holes 1031 are configured to communicate with the function holes 203. That is, a projection of the first through-hole 1031 on the outer surface 202 covers at least a part of the function hole 203, so that the first filter layer 101 and the second filter layer 102 corresponding to the first through-holes 1031 can filter water that enters the function holes 203, and acoustic waves and filtered water can enter the function holes 203 through the first through-holes 1031.

It may be understood that, a center line of the first through-hole 1031 is collinear with a center line of the function hole 203, and a projection of each first through-hole 1031 on the outer surface 202 may fully overlap. In this case, the projection of the first through-hole 1031 on the outer surface 202 may partially overlap or fully overlap with a projection of the function hole 203. Certainly, the function hole 203 may be located inside the projection of the first through-hole 1031 on the outer surface 202. In this way, a loss of acoustic waves when passing through the filtration apparatus 10 can be reduced.

Still refer to FIG. 8 and FIG. 9. The filtration apparatus 10 provided in this embodiment further includes a first support layer 105. The first support layer 105 is disposed between the second filter layer 102 and the outer surface 202 (as shown in FIG. 7), the first support layer 105 is attached to the outer surface 202, and second through-holes 1051 that are configured to communicate with the function holes 203 are provided on the first support layer 105. In this way, the second filter layer 102 close to the outer surface 202 may be supported on the outer surface 202 by the first support layer 105, to avoid direct contact between the second filter layer 102 and the outer surface 202, and avoid damage to the second filter layer 102 caused by the outer surface squeezing the second filter layer 102.

For example, a center line of the second through-hole 1051 may be collinear with a center line of the first through-hole 1031, and a projection of the second through-hole 1051 on the outer surface 202 may fully overlap with a projection of the first through-hole 1031 on the outer surface 202, or a projection of the second through-hole 1051 on the outer surface 202 is located inside a projection of the first through-hole 1031 on the outer surface 202. The first support layer 105 may be a silicone layer or a waterproof adhesive tape layer, or the first support layer 105 includes a waterproof adhesive tape layer and a steel sheet that are disposed along a direction away from the outer surface 202 in a laminated manner. Correspondingly, both the waterproof adhesive tape layer and the steel sheet have holes to communicate with the function holes 203, so that sealing between the second filter layer 102 and the outer surface is implemented and it is ensured that the first support layer 105 has supporting effect.

Still refer to FIG. 7 and FIG. 8. In some embodiments, the filtration apparatus 10 further includes a cover plate 106. The cover plate 106 covers the outer surface 202 of the housing body 20, and the first filter layer 101 and the second filter layers 102 are interposed between the cover plate 106 and the outer surface 202. In other words, the first filter layer 101 and the second filter layers 102 are located between the cover plate 106 and the outer surface 202. The first filter layer 101 and the second filter layers 102 may be fastened on the housing body 20 by using the cover plate 106.

For example, the cover plate 106 may be bonded to the outer surface 202 of the housing body 20 by using an adhesive, to fasten the cover plate 106. The adhesive may be a gum or the like, to facilitate installation of the cover plate 106. Correspondingly, a glue containing groove 204 may be provided on the outer surface 202, and the glue containing groove 204 may accommodate the adhesive, to avoid an excessively large distance between the cover plate 106 and the outer surface 202. Certainly, the cover plate 106 may also be connected to the housing body 20 in a detachable manner such as a snap-fit or a bolt connection, to detach the filtration apparatus 10 from the housing body 20 during maintenance. In some implementations, when the cover plate 106 is connected to the housing body 20 by a bolt connection or a snap-fit, an adhesive is also disposed between the cover plate 106 and the housing body 20, to further improve sealing performance.

Third through-holes 1061 that are configured to communicate with the function holes 203 are provided on the cover plate 106, that is, a center line of the third through-hole 1061 may be collinear with a center line of the function hole 203, and the function hole 203 may be located inside a projection of the third through-hole 1061 on the outer surface 202. In this way, after passing through the third through-holes 1061, external acoustic waves and water may enter the housing body 20 through the function holes 203, and are received by the sound module 40; or after passing through the function holes 203, acoustic waves sent by the sound module 40 is propagated to the outside of the housing body 20 through the third through-holes 1061.

Still refer to FIG. 9. A second bonding layer 104 may be disposed between the cover plate 106 and the first filter layer 101, and fourth through-holes 1041 that are configured to communicate with the function holes 203 are provided on the second bonding layer 104. In this way, the second bonding layer 104 may fasten the filtration apparatus 10 on the cover plate 106, to implement pre-installation of the filtration apparatus 10. Then, the cover plate 106 with the first filter layer 101 and the second filter layers 102 is installed on the housing body 20, so that installation of the filtration apparatus 10 can be completed, and an installation process is simplified.

For example, a center line of the fourth through-hole 1041 may be collinear with a center line of the first through-hole 1031, and a projection of the fourth through-hole 1041 on the outer surface 202 may fully overlap with a projection of the first through-hole 1031 on the outer surface 202; or a projection of the fourth through-hole 1041 on the outer surface 202 is located inside a projection of the first through-hole 1031 on the outer surface 202.

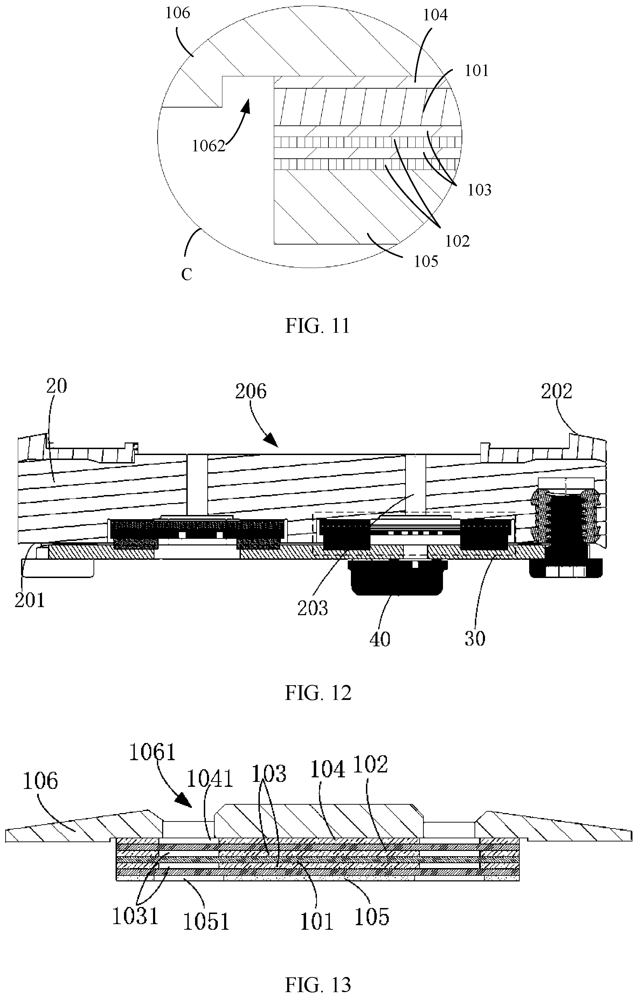

Refer to FIG. 11. In the foregoing implementation, a first groove 1062 may be provided on a surface that is of the cover plate 106 and that faces the outer surface 202, and correspondingly, at least a part of the first filter layer 101 is accommodated in the first groove 1062. In this way, a relatively large distance between the cover plate 106 and the outer surface 202 caused by the first filter layer 101 and the second filter layers 102 being interposed between the cover plate 106 and the outer surface 202 may be avoided, so that structural compactness of the electronic device is improved and a volume of the electronic device is reduced.

For example, the first filter layer 101 may be completely accommodated in the first groove 1062. Certainly, at least a part of the second filter layers 102 may also be accommodated in the first groove 1062, to further improve structural compactness of the electronic device and reduce a volume of the electronic device.

Refer to FIG. 12. In this embodiment, a second groove 206 is provided on the outer surface 202, and correspondingly, at least a part of the second filter layers 102 is accommodated in the second groove 206. In this way, a relatively large distance between the cover plate 106 and the outer surface 202 caused by the first filter layer 101 and the second filter layers 102 being interposed between the cover plate 106 and the outer surface 202 may be avoided, so that structural compactness of the electronic device is improved and a volume of the electronic device is reduced.

For example, when the cover plate 106 covers the outer surface 202, both the first filter layer 101 and the second filter layers 102 may be accommodated in the second groove 206, to further improve structural compactness of the electronic device and reduce a volume of the electronic device. Certainly, in an implementation in which the first groove 1062 is provided on the surface that is of the cover plate 106 and that faces the outer surface 202, a part of the first filter layer 101 is accommodated in the first groove 1062, and correspondingly, the remaining part of first filter layer 101 and second filter layers 102 are accommodated in the second groove 206. In this way, the first groove 1062 and the second groove 206 jointly accommodate the filtration apparatus 10, which can avoid excessively large depths of the first groove 1062 and the second groove 206.

Refer to FIG. 13. In an implementation in which the first filter layer 101 is a rigid layer and the second filter layer 102 is a dust filter, there are two second filter layers 102, the two second filter layers 102 are arranged in a laminated manner, the first filter layer 101 is located between the two second filter layers 102, and along a direction away from the outer surface and in a cross-section parallel to the first filter layer 101, a cross-section area of a second mesh hole on each second filter layer 102 gradually increases. In this way, the first filter layer 101 may be interposed between the two second filter layers 102, so that exposure of the first filter layer 101 is avoided and decoration effect of the electronic device is improved. In this case, a cross-sectional area of the first mesh hole on the first filter layer 101 may be greater than a cross-sectional area of the second mesh hole on each second filter layer 102.

Still refer to FIG. 13. The filtration apparatus 10 further includes first bonding layers 103, the first bonding layers 103 are disposed between the first filter layer 101 and the second filter layers 102, and first through-holes 1031 that communicate with the function holes 203 are provided on the first bonding layers 103. The first bonding layers 103 may implement a connection between the first filter layer 101 and each second filter layer 102, and may implement sealing between the first filter layer 101 and each second filter layer 102.

An embodiment of this application further provides an electronic device. The electronic device may include a mobile phone, a smart watch (as shown in FIG. 1), a PC, a tablet computer, a VR, an AR, a headset, and the like. The electronic device is not limited in this embodiment.

As shown in FIG. 3, the electronic device includes a housing body 20. The housing body 20 may be a housing of the electronic device, and the housing body 20 is disposed around a cavity configured to accommodate apparatuses such as a battery and a circuit board in the electronic device. The housing body 20 has an inner surface 201 and an outer surface 202 that are disposed opposite to each other. It may be understood that the inner surface 201 may be a surface that faces the inside of the electronic device (for example, a cavity wall of a cavity), and correspondingly, the outer surface 202 is an exposed surface the housing body 20. The housing body 20 is provided with function holes 203 that penetrate through the inner surface 201 and the outer surface 202. The function hole 203 may be a balance hole (for example, the function hole 203 on the left side in FIG. 3). The balance hole may balance atmospheric pressure inside and outside the housing body, so that a speaker and a microphone can work normally. Certainly, the function hole 203 may also be a hole (for example, the function hole 203 on the right side in FIG. 3) for acoustic waves to pass through.

The filtration apparatus 10 provided in any one of the foregoing embodiments is disposed on the outer surface 202 of the housing body 20, to filter water that flows into the function holes 203, so that impurities such as particulate matter are prevented from entering the function holes 203.

The electronic device further includes a sound module 40, where the sound module 40 may be an apparatus that sends acoustic waves such as a speaker. Certainly, the sound module 40 may also be an apparatus that receives acoustic waves such as a microphone. This embodiment does not limit the sound module 40.

The sound module 40 is disposed on the inner surface 201, and the sound module 40 is disposed to face the function hole 203, so that the sound module 40 sends acoustic waves to the outside through the function hole 203, or receives acoustic waves outside the housing body 20 through the function hole 203.

As shown in FIG. 3, the electronic device further includes a waterproof assembly 30. The waterproof assembly 30 is disposed on the housing body 20. The waterproof assembly 30 may be disposed to correspond to the sound module 40, to allow acoustic waves to pass through, and the waterproof assembly 30 prevents water from passing through. Certainly, the waterproof assembly 30 may also be located inside the balance hole (for example, the function hole 203 on the left side of FIG. 3). In this case, the waterproof assembly 30 allows air to pass through and prevents water from passing through, so that sealing of the function holes 203 is implemented.

In this embodiment, the waterproof assembly 30 may be disposed in a plurality of positions and a plurality of structures, as long as water can be prevented from passing through and gas is allowed to pass through. The following describes a structure and a disposed location of the waterproof assembly 30 in a plurality of scenarios.

### Scenario 1

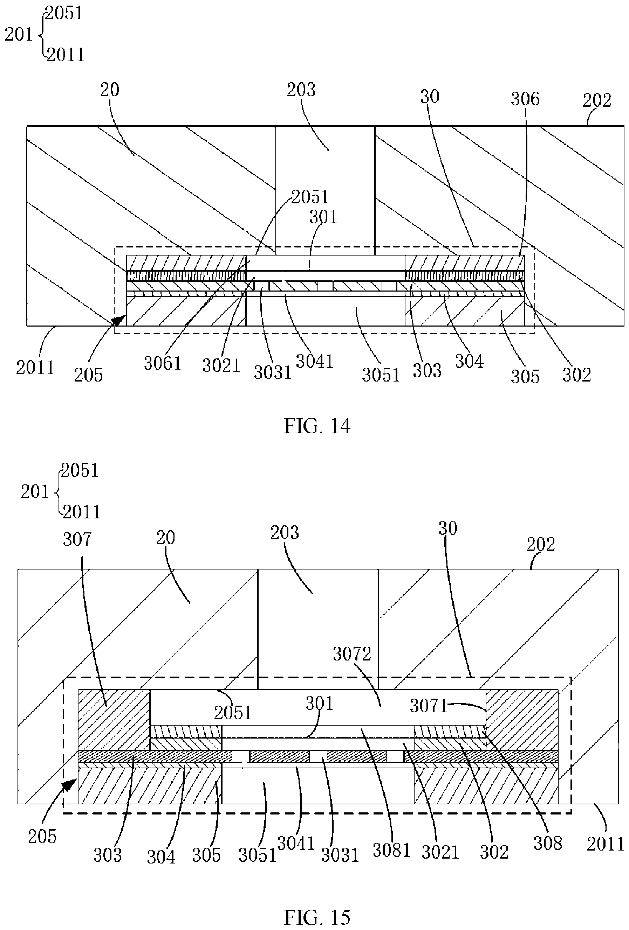

As shown in FIG. 14, in this scenario, the waterproof assembly 30 may be disposed on the inner surface 201, and correspondingly, the waterproof assembly 30 needs to be located between the housing body 20 and the sound module 40, or the waterproof assembly 30 is disposed to correspond to the balance hole, to implement sealing of the function holes 203. Correspondingly, the waterproof assembly 30 may include a waterproof membrane 301, a third bonding layer 302, a second support layer 303, and a fourth bonding layer 304 that are arranged in a laminated manner along a direction away from the inner surface 201. A fifth through-hole 3021 is provided on the third bonding layer 302, a sixth through-hole 3041 is provided on the fourth bonding layer 304, and both the fifth through-hole 3021 and the sixth through-hole 3041 are provided to communicate with the function hole 203. That is, center lines of the fifth through-hole 3021 and the sixth through-hole 3041 may be collinear with a center line of the function hole 203, projections of the fifth through-hole 3021 and the sixth through-hole 3041 on the inner surface 201 may fully overlap, and the function hole 203 may be located inside the projections of the fifth through-hole 3021 and the sixth through-hole 3041 on the inner surface 201, or the function hole 203 may fully overlap with the projections of the fifth through-hole 3021 and the sixth through-hole 3041 on the inner surface 201, so that the third bonding layer 302 and the fourth bonding layer 304 are prevented from obstructing propagation of acoustic waves.

The waterproof assembly 30 further includes a buffer layer 305. The buffer layer 305 is disposed on a side that is of the fourth bonding layer 304 and that is away from the inner surface 201. A seventh through-hole 3051 that communicates with the function hole 203 is provided on the buffer layer 305. The buffer layer 305 may support the whole waterproof assembly 30.

The waterproof membrane 301 has a micro-pore structure, and some air may pass through the micro-pore structure. Water has surface tension, and it is difficult for water to pass through the micro-pore structure, so that the waterproof assembly 30 can prevent water from passing through and allow acoustic waves to pass through, so that sealing is implemented. In this case, the corresponding waterproof assembly 30 is disposed at the balance hole or disposed to correspond to the sound module 40. A material of the waterproof membrane 301 may include expanded PTFE, and a hole diameter range of the micro-pore structure in the waterproof membrane 301 may be 0.05 µm to 10 µm, for example, 0.085 µm, 0.1 µm, or the like, so that water pressure that the waterproof membrane 301 can withstand may reach 1.25 MPa, an underwater usability depth may reach 125 meters, a breathable amount is provided, and a sound blocking amount is not greater than 5 dB at a sound frequency of 100 Hz to 10000 Hz. In related technologies, the waterproof assembly includes a polymeric film on which hydrophobic modification processing is performed, and the polymeric film is a dense film, that is, the polymeric film does not allow gas to pass through, and implements transmission of acoustic waves on two sides of the polymeric film through vibration of the polymeric film. An elastic modulus of the polymeric film is 2000 Mpa to 8000 MPa. At a sound frequency of 100 Hz to 10000 Hz, a sound blocking amount is 1.5 dB to 6 dB, and surface energy of the polymeric film is less than 50 mN/m, so that an electronic device using the polymeric film can withstand water pressure of more than 1 MPa, and an underwater usability depth may reach 100 meters. However, because the polymeric film does not allow gas to pass through, when external atmospheric pressure changes, the polymeric film is easily deformed (for example, bulged or dented) under an action of internal and external atmospheric pressure, and transmission of acoustic waves is affected. In comparison, the waterproof assembly 30 uses the waterproof membrane 301 in this embodiment. Because the waterproof membrane 301 has the micro-pore structure, it can be ensured that the waterproof membrane 301 can withstand relatively large water pressure (for example, 1.25 MPa) without affecting transmission of acoustic waves due to a change of external atmospheric pressure. It may be understood that, in an implementation in which the waterproof assembly 30 is disposed to correspond to a speaker, a breathable membrane such as a waterproof membrane 301 having a micro-pore structure may be used. In an implementation in which the waterproof assembly 30 is disposed to correspond to a microphone, a waterproof membrane 301 having a micro-pore structure or a dense film may be used. When the waterproof assembly 30 is configured to seal the balance hole, the corresponding waterproof membrane 301 needs to be a breathable film such as a waterproof membrane 301 having a micro-pore structure.

A plurality of first holes 3031 are provided at intervals in a region that is of the second support layer 303 and that faces the function hole 203. In other words, the function hole 203 is located in a projection on the inner surface 201 of the region, or the function hole 203 fully overlaps with a projection on the inner surface 201 of the region. In a use process, air may pass through the second support layer 303 through the first holes 3031.

As shown in FIG. 14, projections of the fifth through-hole 3021, the sixth through-hole 3041, and the seventh through-hole 3051 on the inner surface 201 may fully overlap with the region in which the first holes 3031 are provided, and the function hole 203 is located in projections of the fifth through-hole 3021, the sixth through-hole 3041, and the seventh through-hole 3051 on the inner surface 201.

In the foregoing implementation, the second support layer 303 may be rigid. For example, a material of the second support layer 303 may include stainless steel, copper, and the like, so that the second support layer 303 can better support the waterproof membrane 301.

Still refer to FIG. 14. A first accommodating groove 205 is provided on the housing body 20, and the waterproof assembly 30 is accommodated in the first accommodating groove 205. In this way, structural compactness of the electronic device can be improved, and a volume of the electronic device can be reduced. It may be understood that, in this case, the inner surface 201 of the housing body 20 includes a first groove bottom 2051 of the first accommodating groove 205 and a part of a first housing wall 2011 outside the first accommodating groove 205.

Still refer to FIG. 14. The waterproof assembly 30 further includes a fifth bonding layer 306. The fifth bonding layer 306 is disposed between the waterproof membrane 301 and the inner surface 201 (that is, between the waterproof membrane 301 and the first groove bottom 2051). An eighth through-hole 3061 that communicates with the function hole 203 is provided on the fifth bonding layer 306. The fifth bonding layer 306 may implement a connection between the waterproof membrane 301 and the housing body 20, and the fifth bonding layer 306 may also implement sealing between the waterproof membrane 301 and the housing body 20.

For example, a center line of the eighth through-hole 3061 may be collinear with a center line of the fifth through-hole 3021, and a projection on the inner surface 201 of the eighth through-hole 3061 may fully overlap with a proj ection on the inner surface 201 of the fifth through-hole 3021, so that acoustic waves may be transferred to the waterproof membrane 301 through the eighth through-hole 3061.

Still refer to FIG. 14. In this scenario, a material of the buffer layer 305 may include polyurethane foam, silicone, polyethylene foam adhesive, and the like, so that the buffer layer 305 has a specific compression amount. In a process of installing the waterproof assembly 30, specific pre-pressure may be pressurized between film layers by properly compressing the buffer layer 305 (for example, compressing about 60%), to improve sealing performance between adjacent film layers, and improve sealing performance between the waterproof assembly 30 and the housing body 20. In this way, waterproof performance of the electronic device in a deep water environment is improved, that is, a capability of the electronic device to withstand water pressure is improved, and an underwater usability depth of the electronic device is increased. For example, the third bonding layer 302, the fourth bonding layer 304, and the fifth bonding layer 306 are all ring-shaped, an outer circle diameter is 4 millimeters, and an inner circle diameter is 1.75 millimeters, and when the buffer layer 305 is compressed by 50%, the obtained pre-pressure can meet a sealing requirement of an underwater usability depth of 50 meters. To meet a water depth of more than 125 meters, the buffer layer 305 of a same material needs to be compressed by more than 80% to obtain sufficient pre-pressure.

It may be understood that excessively large pre-pressure easily causes the waterproof membrane 301 to wrinkle, and acoustic performance is affected. Excessively small pre-pressure easily causes excessively small bonding force between bonding layers, and sealing performance is insufficient. Correspondingly, a buffer layer 305 with a relatively smooth stress-strain curve may be used, so that a relatively small change of thickness does not cause an excessively large change of the pre-pressure.

In some implementations, an elastic modulus of the buffer layer 305 may be appropriately increased, so that when same pre-pressure is obtained, deformation of the buffer layer 305 may be reduced (for example, 50% compression), so that the deformation of the buffer layer 305 is within a usage range.

In this scenario, a projection area of the waterproof membrane 301 on the inner surface 201 may be appropriately increased, to further increase projection areas of the third bonding layer 302, the fourth bonding layer 304, and the fifth bonding layer 306 on the inner surface 201, thereby improving sealing performance of the third bonding layer 302, the fourth bonding layer 304, and the fifth bonding layer 306. Therefore, during assembly, pre-pressure on the buffer layer 305 may be reduced, to avoid damage to the buffer layer 305. In addition, the waterproof membrane 301 may further be prevented from being wrinkled due to overlarge force bearing, and transmission of acoustic waves is affected.

It may be understood that the waterproof membrane 301 may be in a regular shape, for example, a circle or a rectangle.

Certainly, because the housing body 20 is generally provided with a structure such as a bolt. To avoid attaching to the structure such as the bolt, the waterproof membrane 301 may be in an irregular shape. The shape of the waterproof membrane 301 is not limited in this embodiment. Correspondingly, outer edges of the third bonding layer 302, the fourth bonding layer 304, and the fifth bonding layer 306 are flush with an outer edge of the waterproof membrane 301. To be specific, projections of the third bonding layer 302, the fourth bonding layer 304, and the fifth bonding layer 306 on the inner surface 201 fully overlap. A projection area of the third bonding layer 302, the fourth bonding layer 304, and the fifth bonding layer 306 on the inner surface 201 may be 10 mm² to 40 mm² (for example, 10 mm², 14 mm², 20 mm², 40 mm², or the like). In addition, it needs to be ensured that a bonding width (a width between an outer edge of the third bonding layer 302 and a hole wall of the fifth through-hole 3021) of the third bonding layer 302 is 1.2 mm to 3 mm (for example, 1.2 mm, 2 mm, 3 mm, or the like). In this way, when each bonding layer has sufficient bonding force to ensure sufficient sealing performance, the pre-pressure may be reduced to avoid damage to the buffer layer 305; and in addition, the waterproof membrane 301 may be prevented from being wrinkled due to overlarge force bearing, and transmission of acoustic waves is affected.

In this scenario, during assembly, the fifth bonding layer 306, the waterproof membrane 301, the third bonding layer 302, the second support layer 303, the fourth bonding layer 304, and the buffer layer 305 may be sequentially attached to the housing body 20, to implement assembly of the waterproof assembly 30. Certainly, alternatively, the fourth bonding layer 304, the second support layer 303, the third bonding layer 302, the waterproof membrane 301, and the fifth bonding layer 306 may be first sequentially attached to the buffer layer 305, to form a pre-installed assembly, and then the assembly is assembled to the housing body 20 as a whole, to complete assembly of the waterproof assembly 30, so that assembly of the electronic device is simplified.

### Scenario 2

Refer to FIG. 15. In this scenario, the waterproof assembly 30 may be disposed on the inner surface 201, and correspondingly, the waterproof assembly 30 needs to be located between the housing body 20 and the sound module 40, or the waterproof assembly 30 is disposed to correspond to the balance hole, to implement sealing of the function hole 203. Correspondingly, the waterproof assembly 30 may include: a waterproof membrane 301, a third bonding layer 302, a second support layer 303, a fourth bonding layer 304, and a buffer layer 305 that are arranged in a laminated manner along a direction away from the inner surface 201. A fifth through-hole 3021 is provided on the third bonding layer 302, a sixth through-hole 3041 is provided on the fourth bonding layer 304, a seventh through-hole 3051 is provided on the buffer layer 305, and the fifth through-hole 3021, the sixth through-hole 3041, and the seventh through-hole 3051 are all configured to communicate with the function hole 203. In other words, center lines of the fifth through-hole 3021, the sixth through-hole 3041, and the seventh through-hole 3051 may be collinear with a center line of the function hole 203, and projections of the fifth through-hole 3021, the sixth through-hole 3041, and the seventh through-hole 3051 on the inner surface 201 may fully overlap, in addition, the function hole 203 may be located inside the projections of the fifth through-hole 3021, the sixth through-hole 3041, and the seventh through-hole 3051 on the inner surface 201, or the function hole 203 may fully overlap with the projections of the fifth through-hole 3021, the sixth through-hole 3041, and the seventh through-hole 3051 on the inner surface 201. This prevents the third bonding layer 302, the fourth bonding layer 304, and the buffer layer 305 from obstructing propagation of acoustic waves.

The waterproof membrane 301 may have a micro-pore structure, and some air may pass through the micro-pore structure. Water has surface tension, and it is difficult for water to pass through the micro-pore structure, so that the waterproof assembly 30 can prevent water from passing through and allow acoustic waves to pass through, so that sealing is implemented. A material of the waterproof membrane 301 may include expanded PTFE.

A plurality of first holes 3031 are provided at intervals in a region that is of the second support layer 303 and that faces the function hole 203. In other words, the function hole 203 is located in a projection on the inner surface 201 of the region, or the function hole 203 fully overlaps with a projection on the inner surface 201 of the region. In a use process, air may pass through the second support layer 303 through the first holes 3031.

As shown in FIG. 15, projections of the fifth through-hole 3021, the sixth through-hole 3041, and the seventh through-hole 3051 on the inner surface 201 may fully overlap with the region in which the first holes 3031 are provided, and the function hole 203 is located in the projections of the fifth through-hole 3021, the sixth through-hole 3041, and the seventh through-hole 3051 on the inner surface 201.

In the foregoing implementation, the second support layer 303 may be rigid. For example, a material of the second support layer 303 may include stainless steel, copper, and the like, so that the second support layer 303 can better support the waterproof membrane 301.

Refer to FIG. 15. A first accommodating groove 205 is provided on the housing body 20, and the waterproof assembly 30 is accommodated in the first accommodating groove 205. In this way, structural compactness of the electronic device can be improved, and a volume of the electronic device can be reduced. It may be understood that, in this case, the inner surface 201 of the housing body 20 includes a first groove bottom 2051 of the first accommodating groove 205 and a part of a first housing wall 2011 outside the first accommodating groove 205.

Still refer to FIG. 15. The waterproof assembly 30 further includes a third support layer 307. The third support layer 307 is disposed on the inner surface 201 (that is, the first groove bottom 2051), and an accommodating channel 3071 that communicates with the function hole 203 is provided on the third support layer 307. The waterproof membrane 301 is accommodated in the accommodating channel 3071, the waterproof membrane 301 is attached to a side wall of the accommodating channel 3071, and there is an interstice 3072 between the waterproof membrane 301 and the inner surface 201 (that is, the first groove bottom 2051) (forming a U-shaped cavity structure). In this way, the third support layer 307 is supported between the second support layer 303 and the housing body 20, and there is the interstice 3072 between the waterproof membrane 301 and the inner surface (that is, the first groove bottom 2051). When pre-pressure is pressurized to the housing body 20 by using the buffer layer 305 in an installation process, the pre-pressure acts on the third support layer 307, and the waterproof membrane 301 is prevented from being wrinkled due to the pre-pressure, so that impact on acoustic performance caused by the wrinkle is avoided.

In the foregoing implementation, the second support layer 303 may be in contact with a surface that is of the third support layer 307 and that is away from the inner surface 201. In other words, the second support layer 303 is in contact with a surface that is of the third support layer 307 and that is away from the first groove bottom 2051. Correspondingly, the third support layer 307 may include a silicone layer. In this way, sealing between the second support layer 303 and the housing body 20 can be implemented and specific support effect is ensured. Water pressure that the electronic device can withstand may reach 1 MPa (about 10 atm), that is, an underwater usability depth of the electronic device may reach 100 meters. Certainly, the third support layer 307 may also be another rubber layer or the like.

Still refer to FIG. 15. During assembly, the fourth bonding layer 304, the second support layer 303, the third bonding layer 302, the waterproof membrane 301, and the fifth bonding layer 306 may be first sequentially attached to the buffer layer 305, then the third support layer 307 is attached to the second support layer 303, to form a pre-installed assembly, and then the assembly is assembled to the housing body 20 as a whole, to complete assembly of the waterproof assembly 30, so that assembly of the electronic device is simplified. Certainly, alternatively, the fourth bonding layer 304, the second support layer 303, the third bonding layer 302, and the third support layer 307 may be first sequentially attached to the buffer layer 305, and then the waterproof membrane 301 and the fifth bonding layer 306 are sequentially attached to the second support layer 303, to form a pre-installed assembly. Then, the assembly is assembled to the housing body 20 as a whole.

Still refer to FIG. 15. The third bonding layer 302 may be waterproof adhesive tape. Because there is the interstice 3072 between the waterproof membrane 301 and the first groove bottom 2051, during assembly, only the third bonding layer 302 needs to be performed activation treatment. In a use process, water pressure acts on the waterproof membrane 301, and the third bonding layer 302 is squeezed, so that bonding between the waterproof membrane 301 and the second support layer 303 can be automatically implemented.

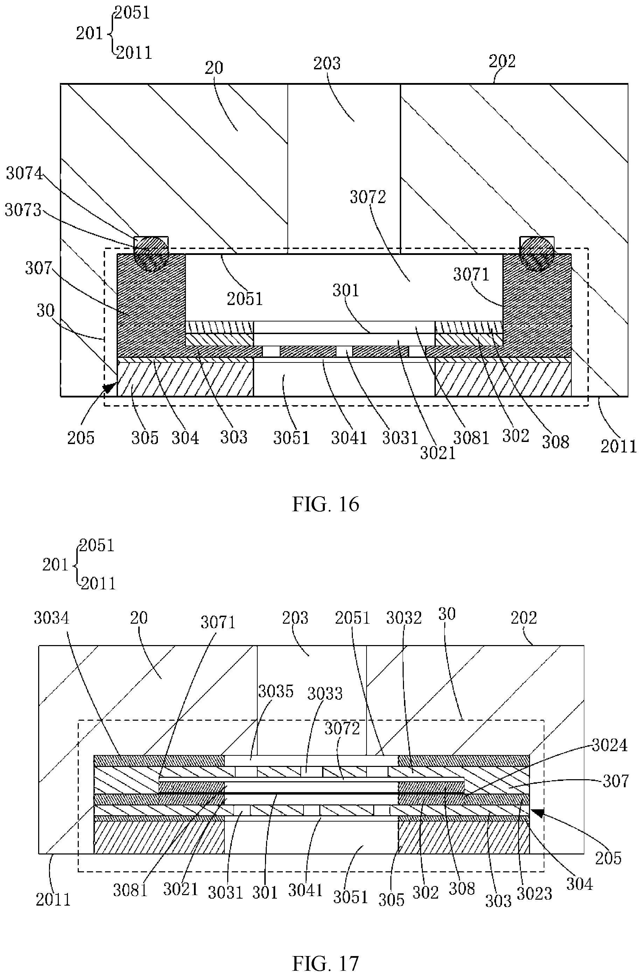

Refer to FIG. 16. In another implementation, a third support layer 307 and a second support layer 303 may be of an integrated structure. In this way, the integrated structure is formed by a stamping process, an injection molding process, or the like, so that a structure of the waterproof assembly 30 is simplified, and assembly of the waterproof assembly 30 is facilitated.

Still refer to FIG. 16. A sealing ring (O-ring) 3073 is disposed between the third support layer 307 and the housing body 20, and the sealing ring 3073 is disposed surrounding the function hole 203, that is, the sealing ring 3073 surrounds the outer side of the function hole 203. In this way, sealing performance between the third support layer 307 and the housing body 20, so that waterproof performance of the electronic device in a deep water environment is improved, that is, a capability of the electronic device to withstand water pressure is improved, and an underwater usability depth of the electronic device is increased. For example, the waterproof assembly 30 shown in FIG. 16 is used, water pressure that the electronic device can withstand may reach 1 MPa (about 10 atm), that is, an underwater usability depth of the electronic device may reach 100 meters.

It may be understood that a ring groove 3074 may be provided on the inner surface 201 (that is, the first groove bottom 2051), the sealing ring 3073 is disposed in the ring groove 3074, and a part of the sealing ring 3073 protrudes from the ring groove 3074. One end that is of the third support layer 307 and that faces the inner surface 201 (that is, the first groove bottom 2051) is in contact with the sealing ring 3073 located outside the ring groove 3074. Certainly, a ring groove 3074 may be provided on both the inner surface 201 and the end that is of the third support layer 307 and that faces the inner surface 201 (that is, the first groove bottom 2051). Correspondingly, a part of the sealing ring 3073 is located in the ring groove 3074 on the inner surface 201 (that is, the first groove bottom 2051), and the remaining part of the sealing ring 3073 is located in the ring groove 3074 on the third support layer 307.

Still refer to FIG. 16. During assembly, the fourth bonding layer 304 and the second support layer 303 may be first sequentially attached to the buffer layer 305, and then the third bonding layer 302 and the waterproof membrane 301 are sequentially attached to the second support layer 303, to form a pre-installed assembly. Then, the assembly is assembled to the housing body 20, so that assembly of the electronic device is simplified.

Still refer to FIG. 16. The third bonding layer 302 may be waterproof adhesive tape. Because there is the interstice 3072 between the waterproof membrane 301 and the first groove bottom 2051, during assembly, only the third bonding layer 302 needs to be performed activation treatment. In a use process, water pressure acts on the waterproof membrane 301, and the third bonding layer 302 is squeezed, so that bonding between the waterproof membrane 301 and the second support layer 303 can be automatically implemented.

Refer to FIG. 17. The waterproof assembly 30 in this scenario may further include an auxiliary support layer 3032. The auxiliary support layer 3032 is disposed between the third support layer 307 and the housing body 20 (that is, the first groove bottom 2051). A plurality of second holes 3033 are provided at intervals in a region that is of the auxiliary support layer 3032 and that faces the function hole 203, so that acoustic waves can pass through the auxiliary support layer 3032 through the second holes 3033. In this way, the waterproof membrane 301 is interposed between the second support layer 303 and the auxiliary support layer 3032, so that effect of supporting the waterproof membrane 301 can be improved.

Correspondingly, an interstice 3072 is located between the waterproof membrane 301 and the auxiliary support layer 3032, to avoid contact between the waterproof membrane 301 and the auxiliary support layer 3032, so that the waterproof membrane 301 may be prevented from being wrinkled due to force bearing.

It may be understood that the function hole 203 may be located inside a projection of the region in which the second holes 3033 are provided on the housing body 20, or the function hole 203 fully overlaps with a projection of the region in which the second holes 3033 are provided on the housing body 20, so that the region in which the second holes 3033 are provided faces the function hole 203.

In the foregoing implementation, the auxiliary support layer 3032 and the third support layer 307 may be of an integrated structure, and the integrated structure is formed in a stamping or injection molding manner, so that a structure of the waterproof assembly 30 can be simplified, and installation of the waterproof assembly 30 is facilitated.

Still refer to FIG. 17. A seventh bonding layer 3034 may be disposed between the auxiliary support layer 3032 and the inner surface 201 (that is, the first groove bottom 2051). Correspondingly, a tenth through-hole 3035 that communicates with the function hole 203 is provided on the seventh bonding layer 3034. It may be understood that the function hole 203 may be located in a projection on the inner surface 201 of the tenth through-hole 3035, or the function hole 203 fully overlaps with a projection on the inner surface 201 of the tenth through-hole 3035. In this way, the auxiliary support layer 3032 may be fastened to the housing body 20 by using the seventh bonding layer 3034, to fasten the waterproof assembly 30. In addition, sealing between the auxiliary support layer 3032 and the housing body 20 may be implemented.

Still refer to FIG. 17. A sixth bonding layer 3023 is disposed between the third support layer 307 and the second support layer 303, a ninth through-hole 3024 is provided on the sixth bonding layer 3023, the waterproof membrane 301 may be flush with a surface that is of the third support layer 307 and that is away from the inner surface 201, the third bonding layer 302 is located in the ninth through-hole 3024, and the third bonding layer 302 is bonded to a hole wall of the ninth through-hole 3024. In this way, a connection between the third support layer 307 and the second support layer 303 can be implemented by using the sixth bonding layer 3023, and when pre-pressure is pressurized by using the buffer layer 305, the sixth bonding layer 3023 between the second support layer 303 and the third support layer 307 bears the force. In this case, the third bonding layer 302 does not bear the force, so that the third bonding layer 302 and the waterproof membrane 301 on the third bonding layer 302 are prevented from being winkled due to force bearing. In addition, the third bonding layer 302 is bonded to the sixth bonding layer 3023, so that sealing performance between the third support layer 307 and the second support layer 303 can be improved.

Certainly, in another implementation, the waterproof membrane 301 may partially protrude from the accommodating channel 3071. This is not limited in this embodiment.

Still refer to FIG. 17. During assembly, the fourth bonding layer 304, the second support layer 303, the sixth bonding layer 3023, the third bonding layer 302, the waterproof membrane 301, the third support layer 307, and the seventh bonding layer 3034 may be first sequentially attached to the buffer layer 305, to form a pre-installed assembly, and then the assembly is assembled to the housing body 20 as a whole, so that assembly of the electronic device is simplified. In addition, the pre-installed assembly may be transported separately, to implement modularization of the electronic device.

For example, the waterproof assembly 30 shown in FIG. 17 is used, water pressure that can be withstood by the electronic device may reach 1 MPa (about 10 atm), that is, an underwater usability depth of the electronic device may reach 100 meters.

Still refer to FIG. 17. The third bonding layer 302 may be waterproof adhesive tape. Because there is the interstice 3072 between the waterproof membrane 301 and the auxiliary support layer 3032, during assembly, only the third bonding layer 302 needs to be performed activation treatment. In a use process, water pressure acts on the waterproof membrane 301, and the third bonding layer 302 is squeezed, so that bonding between the waterproof membrane 301 and the second support layer 303 can be automatically implemented.

Still refer to FIG. 15 to FIG. 17. In this scenario, the waterproof assembly 30 further includes a protective layer 308. The protective layer 308 is disposed on a surface that is of the waterproof membrane 301 and that faces the inner surface 201 (that is, the first groove bottom 2051), and a via hole 3081 that communicates with the function hole 203 is provided on the protective layer 308. It may be understood that the function hole 203 may be located in a projection on the inner surface 201 of the via hole 3081, or the function hole 203 fully overlaps with a projection on the inner surface 201 of the via hole 3081.

Correspondingly, an interstice 3072 is located between the protective layer 308 and the inner surface 201 (that is, the first groove bottom 2051). In this way, under an action of water pressure, the protective layer 308 may enable the waterproof membrane 301 to withstand relatively uniform force, to avoid being winkled. In addition, the protective layer 308 may play a supporting role, to avoid tilting of an edge of the waterproof membrane 301. For example, a material of the protective layer 308 may include polyethylene terephthalate (polyethylene glycol terephthalate, PET) and the like.

### Scenario 3

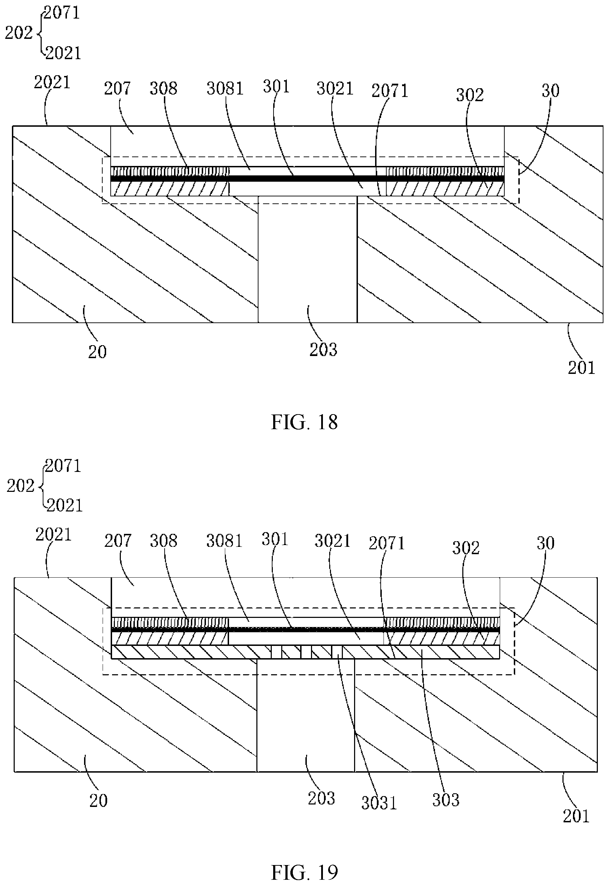

Refer to FIG. 18. A difference between this scenario and Scenario 1 and Scenario 2 lies in that a disposed position of the waterproof assembly 30 is different. The waterproof assembly 30 may be disposed on the outer surface 202, and correspondingly, the waterproof assembly 30 needs to be located between the housing body 20 and the filtration apparatus 10, to prevent impurities such as particulate matter in water from being in contact with the waterproof assembly 30.

Still refer to FIG. 18. A second accommodating groove 207 is provided on the housing body 20, and correspondingly, a second groove bottom 2071 of the second accommodating groove 207 and a second housing wall 2021 outside the accommodating groove 205 form an outer surface 202. The waterproof assembly 30 may be disposed in the accommodating groove 205, to improve structural compactness of the electronic device and reduce a volume of the electronic device.

The waterproof assembly 30 includes a third bonding layer 302, a waterproof membrane 301, and a protective layer 308 that are arranged in a laminated manner along a direction away from the outer surface 202 (that is, the second groove bottom 2071). A fifth through-hole 3021 that communicates with the function hole 203 is provided on the third bonding layer 302, and a via hole 3081 that communicates with the function hole 203 is provided on the protective layer 308. In this way, the waterproof membrane 301 is fastened to the housing body 20 by using the third bonding layer 302, and sealing between the waterproof membrane 301 and the housing body 20 can be implemented. In addition, during using, water pressure acts on the protective layer 308, and then acts on the third bonding layer 302, so that sealing performance between the waterproof membrane 301 and the housing body 20 can be further improved. Therefore, during assembly, installation can be completed without pressurizing pre-pressure to the waterproof membrane 301 or with pressurizing relatively small pre-pressure to the waterproof membrane 301, so that the waterproof membrane 301 is prevented from being wrinkled by overlarge force bearing.

In the foregoing implementation, the protective layer 308 may enable the waterproof membrane 301 to bear relatively uniform force, to avoid being winkled due to uneven force. In addition, the protective layer 308 may play a supporting role, to avoid tilting of an edge of the waterproof membrane 301.

It may be understood that center lines of the via hole 3081 and the fifth through-hole 3021 may be collinear with a center line of the function hole 203, and the function hole 203 may be located in projections of the via hole 3081 and the fifth through-hole 3021 on the second groove bottom 2071, or the function hole 203 fully overlaps with projections of the via hole 3081 and the fifth through-hole 3021 on the second groove bottom 2071.

Refer to FIG. 19. The waterproof assembly 30 further includes a second support layer 303, the second support layer 303 is disposed between the third bonding layer 302 and the outer surface 202, and a plurality of first holes 3031 are provided at intervals in a region that is of the second support layer 303 and that faces the function hole 203. The second support layer 303 may support the waterproof membrane 30. It may be understood that an adhesive layer (not shown) may be disposed between the second support layer 303 and the outer surface 202, to fasten the second support layer 303 and seal the second support layer 303 and the outer surface 202.

In the electronic device provided in this embodiment, the first filter layer 101 in the filtration apparatus 10 is disposed outside the outer surface 202 of the housing body 20, and a plurality of first mesh holes are provided at intervals on the first filter layer 101. The second filter layer 102 is disposed between the outer surface 202 and the first filter layer 101, a plurality of second mesh holes are provided at intervals on the second filter layer 102, and both the first filter layer 101 and the second filter layer 102 cover the function holes 203 on the housing body 20. In this way, in water, the first filter layer 101 and the second filter layer 102 may filter water that enters the function holes 203, to prevent impurities such as particulate matter in the liquid from entering the function holes 203. Especially in a deep water environment, impurities such as particulate matter may be prevented from damaging the waterproof membrane 301 of the waterproof assembly 30, so that waterproof performance of the electronic device in the deep water environment is improved. That is, a capability of the electronic device to withstand water pressure is improved, and an underwater usability depth of the electronic device is increased.

It should be noted that, in the descriptions of embodiments of this application, unless otherwise specified and limited, the terms "communicate" and "connect" should be understood in a broad sense. For example, they may indicate a fixed connection, or an integrated connection, or may be a mechanical connection, or may be an electrical connection, or may be a direct connection, or may be an indirect connection through an intermediate medium, or may be a communicative connection inside two components. A person skilled in the art may understand specific meanings of the terms in embodiments of this application based on specific situations.

Finally, it should be noted that the foregoing embodiments are merely used for describing the technical solutions of embodiments of this application other than limiting embodiments of this application. Although embodiments of this application are described in detail with reference to the foregoing embodiments, a person of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. A filtration apparatus, configured to be disposed on an electronic device, wherein
the electronic device comprises:
a housing body, wherein the housing body has an inner surface and an outer surface opposite to the inner surface, and function holes that penetrate through the inner surface and the outer surface are provided on the housing body; and
the filtration apparatus comprises:
a first filter layer, wherein the first filter layer is located on an outer side of the outer surface, the first filter layer covers the function holes, and a plurality of first mesh holes are provided at intervals on the first filter layer; and
a second filter layer, wherein the second filter layer is located between the outer surface and the first filter layer, the second filter layer covers the function holes, and a plurality of second mesh holes are provided at intervals on the second filter layer, wherein
in a cross-section parallel to the first filter layer, a cross-section area of the first mesh hole is greater than a cross-section area of the second mesh hole.

2. The filtration apparatus according to claim 1, wherein there are a plurality of second filter layers, and the plurality of second filter layers are arranged in a laminated manner; and in the cross-section parallel to the first filter layer, a cross-section area of the second mesh hole on each second filter layer gradually increases along a direction away from the outer surface.

3. The filtration apparatus according to claim 2, wherein the filtration apparatus further comprises:
a first bonding layer, wherein the first bonding layer is disposed between the first filter layer and the second filter layer close to the first filter layer and between adjacent second filter layers, and first through-holes that communicate with the function holes are provided on the first bonding layer.

4. The filtration apparatus according to claim 1, wherein the filtration apparatus further comprises:
a first support layer, wherein the first support layer is disposed between the second filter layer and the outer surface, the first support layer is attached to the outer surface, and second through-holes that communicate with the function holes are provided on the first support layer.

5. The filtration apparatus according to claim 1, wherein the first filter layer is a rigid filter layer.

6. The filtration apparatus according to claim 5, wherein there are two second filter layers, the two second filter layers are arranged in a laminated manner, the first filter layer is located between the two second filter layers, and in the cross-section parallel to the first filter layer, a cross-section area of the second mesh hole on each second filter layer gradually increases along a direction away from the outer surface.

7. The filtration apparatus according to claim 6, wherein the filtration apparatus further comprises:
a first bonding layer, wherein the first bonding layer is disposed between the first filter layer and the second filter layer, and first through-holes that communicate with the function holes are provided on the first bonding layer.

8. The filtration apparatus according to claim 1, wherein the filtration apparatus further comprises:
a cover plate, wherein the cover plate covers the outer surface, the first filter layer and the second filter layer are located between the cover plate and the outer surface, and third through-holes that communicate with the function holes are provided on the cover plate; and
the cover plate is connected to the housing body.

9. The filtration apparatus according to claim 8, wherein the filtration apparatus further comprises:
a second bonding layer, wherein the second bonding layer is disposed between the cover plate and the first filter layer, and fourth through-holes that communicate with the function holes are provided on the second bonding layer.

10. The filtration apparatus according to claim 8, wherein a first groove is provided on a surface that is of the cover plate and that faces the housing body, and at least a part of the first filter layer is accommodated in the first groove.

11. The filtration apparatus according to claim 8, wherein a second groove is provided on the outer surface, and at least a part of the second filter layer is accommodated in the second groove.

12. The filtration apparatus according to any one of claims 1 to 10, wherein the electronic device further comprises a sound module, the sound module is disposed on the inner surface, and the sound module is disposed at the function hole.

13. An electronic device, comprising:
a housing body, wherein the housing body has an inner surface and an outer surface opposite to the inner surface, and function holes that penetrate through the inner surface and the outer surface are provided on the housing body;
a waterproof assembly, wherein the waterproof assembly is disposed on the function hole, and the waterproof assembly is configured to prevent liquid from passing through the function hole; and
the filtration apparatus according to any one of claims 1 to 12.

14. The electronic device according to claim 13, wherein the waterproof assembly is disposed on the inner surface, and the waterproof assembly comprises:
a waterproof membrane, a third bonding layer, a second support layer, and a fourth bonding layer that are arranged in a laminated manner along a direction away from the inner surface, wherein a fifth through-hole is provided on the third bonding layer, a sixth through-hole is provided on the fourth bonding layer, and both the fifth through-hole and the sixth through-hole communicate with the function hole, wherein
a plurality of first holes are provided at intervals in a region that is of the second support layer and that faces the function hole.

15. The electronic device according to claim 14, wherein the waterproof assembly further comprises a buffer layer, the buffer layer is disposed on a side that is of the fourth bonding layer and that is away from the inner surface, and a seventh through-hole that communicates with the function hole is provided on the buffer layer.

16. The electronic device according to claim 14, wherein the waterproof assembly further comprises:
a fifth bonding layer, wherein the fifth bonding layer is disposed between the waterproof membrane and the inner surface, and an eighth through-hole that communicates with the function hole is provided on the fifth bonding layer.

17. The electronic device according to claim 14, wherein the waterproof assembly further comprises:
a third support layer, wherein the third support layer is disposed on the inner surface, and an accommodating channel that communicates with the function hole is provided on the third support layer, wherein
the waterproof membrane is accommodated in the accommodating channel, an edge of the waterproof membrane is attached to a side wall of the accommodating channel, and an interstice exists between the waterproof membrane and the inner surface.

18. The electronic device according to claim 17, wherein the second support layer is in contact with a surface that is of the third support layer and that is away from the inner surface.

19. The electronic device according to claim 18, wherein the third support layer comprises a silicone layer.

20. The electronic device according to claim 18, wherein the second support layer and the third support layer are of an integrated structure.

21. The electronic device according to claim 20, wherein a sealing ring is disposed between the third support layer and the housing body, and the sealing ring is disposed surrounding the function hole.

22. The electronic device according to claim 17, wherein the waterproof assembly further comprises:
an auxiliary support layer, wherein the auxiliary support layer is disposed between the third support layer and the inner surface, a plurality of second holes are provided at intervals in a region that is of the auxiliary support layer and that faces the function hole, and the interstice is located between the waterproof membrane and the auxiliary support layer.

23. The electronic device according to claim 22, wherein the auxiliary support layer and the third support layer are of an integrated structure.

24. The electronic device according to claim 22, wherein a sixth bonding layer is disposed between the third support layer and the second support layer, a ninth through-hole is provided on the sixth bonding layer, the third bonding layer is located in the ninth through-hole, and the third bonding layer is bonded to a hole wall of the ninth through-hole.

25. The electronic device according to claim 14, wherein the waterproof assembly further comprises:
a protective layer, wherein the protective layer is disposed on a surface that is of the waterproof membrane and that faces the inner surface, and a via hole that communicates with the function hole is provided on the protective layer.

26. The electronic device according to claim 13, wherein a first accommodating groove is provided on the inner surface, and the waterproof assembly is disposed in the first accommodating groove.

27. The electronic device according to claim 13, wherein the waterproof assembly is disposed on the outer surface, and the waterproof assembly comprises:
a third bonding layer, a waterproof membrane, and a protective layer that are arranged in a laminated manner along a direction away from the outer surface, wherein a fifth through-hole that communicates with the function hole is provided on the third bonding layer, and a via hole that is directly opposite to the function hole is provided on the protective layer.

28. The electronic device according to claim 27, wherein the waterproof assembly further comprises a second support layer, the second support layer is disposed between the third bonding layer and the outer surface, and a plurality of first holes are provided at intervals in a region that is of the second support layer and that faces the function hole.

29. The electronic device according to claim 27, wherein a second accommodating groove is provided on the outer surface, and the waterproof assembly is disposed in the second accommodating groove.

30. The electronic device according to claim 13, wherein the electronic device further comprises a sound module, the sound module is disposed on the inner surface, and the sound module is disposed at the function hole.
